# EUROPEAN PATENT SPECIFICATION

(11) **EP 3 933 336 B1**
(45) Date of publication and mention of the grant of the patent: **04.09.2024**
(21) Application number: 21180515.5
(22) Date of filing: 21.06.2021
(51) Int. Cl.: F28D 15/02, F28F 3/02

(54) **HEAT EXCHANGER AND MANUFACTURING METHOD OF THE SAME**
WÄRMETAUSCHER UND HERSTELLUNGSVERFAHREN DAFÜR
ÉCHANGEUR DE CHALEUR ET SON PROCÉDÉ DE FABRICATION

(30) Priority: 01.07.2020 US 202063046721 P
(43) Date of publication of application: 05.01.2022
(73) Proprietor: Cooler Master Co., Ltd., Taipei City 114065 (TW)
(72) Inventor: Lin, Chia-yu, Taipei City 114065 (TW); Cheng, Shan-yin, Taipei City 114065 (TW)
(74) Representative: Grünecker Patent- und Rechtsanwälte PartG mbB

(56) References cited:
- DE-U1- 212013 000 272
- US-A1- 2017 363 366
- US-A1- 2018 283 797
- US-A1- 2018 308 780
- US-B2- 10 517 192

## Description

### TECHNICAL FIELD

Example embodiments relate generally to the field of heat transfer and, more particularly, to heat exchangers according to the preamble of claim 1 and manufacturing methods of the same.

Such a heat exchanger is known from US 2018/308780 A1.

### BACKGROUND

During operation of electric and electronic elements, devices and systems, the heat generated thereby must be dissipated quickly and efficiently to keep operating temperature within manufacturer recommended ranges, under, at times, challenging operating conditions. As these elements, devices and systems increase in functionality and applicability, so does the power requirements thereof, this in turn increases cooling requirements.

Several techniques have been developed for extracting heat from electric and electronic elements, devices and systems. One such technique is an air-cooling system, wherein a heat exchanger is in thermal contact with the elements, devices or systems, transporting heat away therefrom, and then air flowing over the heat exchanger removes heat from the heat exchanger. One type of heat exchanger consists of a plurality of fins extending from a base plate. The plurality of fins increases the rate of convective heat transfer to or from an environment of the heat exchanger, by increasing the surface area of a heat source in thermal contact with the heat exchanger. Heat is transferred from the heat source to the base plate, the base plate to the plurality of fins and the environment, and the plurality of fins to the environment.

Convective heat transfer may be aided by a fan, blower, or any other source, or natural convection may be employed. For natural convection, higher temperature air is less dense than its surrounding air and rises out of the heat exchanger and plurality of fins naturally, opposite the direction of gravity. For natural convection, the attached positioning of the heat exchanger and orientation of the plurality of fins during operation is in a direction that will not block air movement. During operation, when positioned horizontally, the plurality of fins face upward, and when positioned vertically, the plurality of fins is oriented to allow higher temperature air to conveniently rise.

The thermal performance of the plurality of fins of the heat exchangers is dependent on heat transfer effectiveness. Thus, shape, thickness, material, and enhancements all contribute to the thermal performance of the plurality of fins. One heat exchanger fin shape is a rectangular fin shape. The size of the rectangular fin shape is regulated to the square area allotted for the heat exchanger applied to the electric and/or electronic elements, devices and systems. Thus, further increasing the rate of convective heat transfer to or from an environment of the heat exchanger, by increasing the surface area of a heat source in thermal contact with the heat exchanger via the plurality of fins is a challenge.

US 2018/308780 A1 refers to a thermally superconducting radiator comprising a plurality of separators and a plurality of thermally superconducting heat dissipation fins. The separators and the thermally superconducting heat dissipation fins are alternately arranged, and one end face of the separator is flush with one end face of the thermally superconducting heat dissipation fin, so that they together form a mounting surface suitable for mounting a power device. The thermally superconducting heat dissipation fin comprises two plates, which are compounded together by a rolling process. The closed pipes that are interconnected and have a certain structure and shape are formed between the two plates by an inflation process. The closed pipes are filled with a heat transfer working medium. The closed pipe may have a hexagonal or honeycomb shape, a crisscrossed mesh shape, multiple U-shapes connected from head to end in series, a rhombic structure, a triangular structure, a circular structure, or any combinations of any or more of the above. Separators are provided on one side with grooves and intermediate separators are provided on both sides with grooves. The grooves are shaped to match the shape of convex structure of pipes located between the separators. As a result, the separators and the thermally conducting heat dissipation fins can be closely fitted and alternatingly arranged. Gaps remain between the remainder of the dissipation fins.

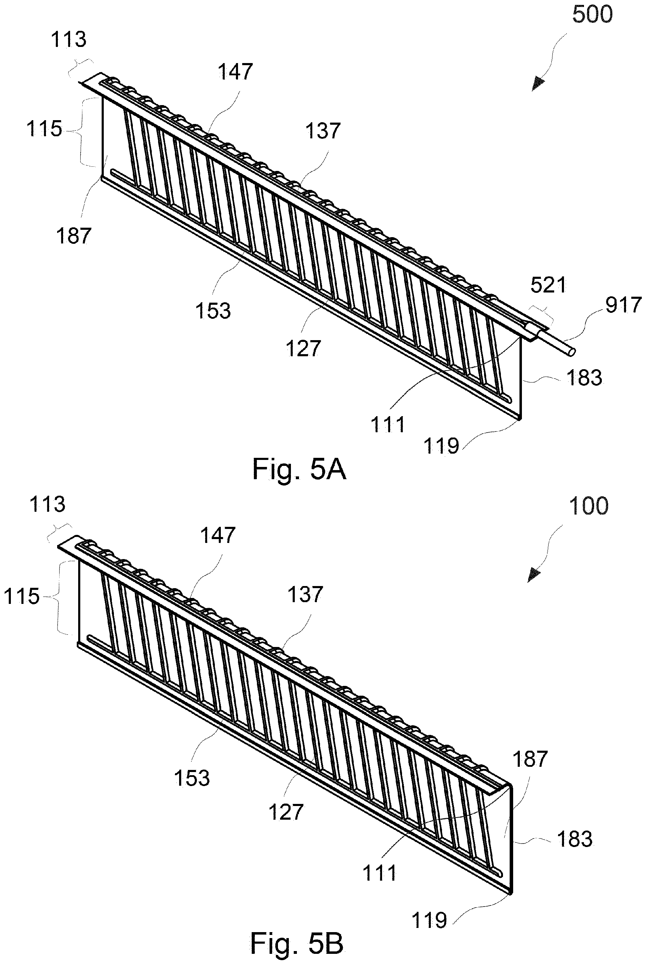

DE 21 2013 000272 U1 relates to a phase change heat transfer device, especially in form of a wing or blade tube. The thermal blade has a hollow sheet shaped casing composed of two sidewalls and frames connecting the sidewalls. A capillary layer is formed on the inner surfaces of the casing. The casing is hollow and partially filled with a phase change working medium. The length and the width of the blade are several times larger than the thickness so that a vapor transmission channel of the thermal blade is relatively large. A thermally driven flow of the working medium is created within the thermal blade. Figures 5, 6, 10 and 11 show different embodiments and configurations of the casing including bend configurations.

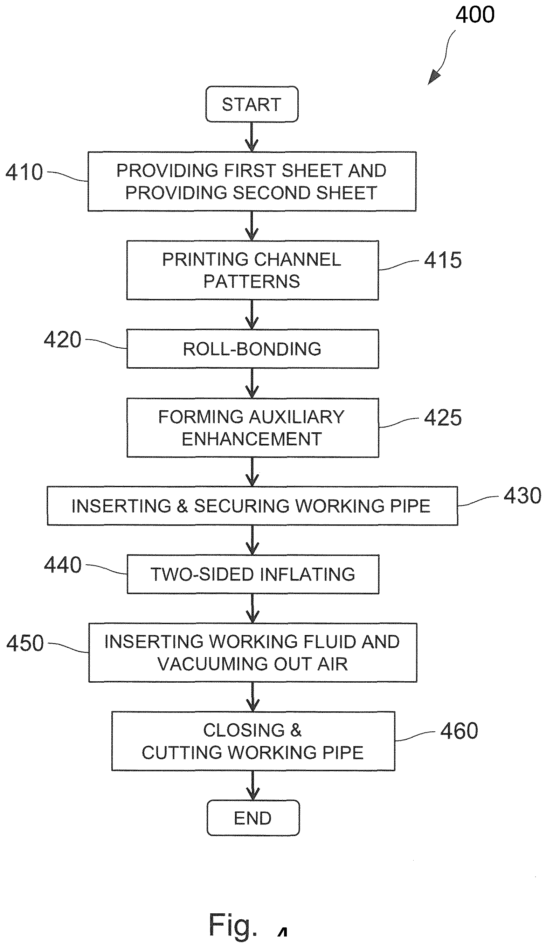

US 2018/283797 A1 relates to a heat sink for cooling heating elements. The heat sink includes a heat receiving plate thermally connected to heating elements. Heat pipes are formed from a tube body thermally connected to the heat receiving plate and heat dissipation fins connected to the heat receiving plate. The heat pipes are provided in a plurality of layers in a vertical direction to a surface of the heat receiving plate. The heat pipes arranged in different layers have different positions in order to equalize the heat transfer therethrough. Some of the heat pipes have a U-shaped configuration. Each heat pipe is substantially a container processed into a flat shape filled with a working fluid in a reduced pressure state. Figure 4 describes an embodiment where two U-shaped heat pipes are directed vertically, such that a straight part is in contact with the surface of the heat receiving plate and the other straight part is only connected to the top part of the heat dissipation fins. The two straight parts and are connected by curved part.

US 2017/363366 A1 relates to a heat dissipation device having a temperature plate with a bent structure and a cooling fins assembly clipped by the bent structure. The temperature plate includes a plate body and a supporting structure. The supporting structure might be disposed in a vacuum chamber of the plate body or on the first surface or on the second surface thereof. The vacuum chamber may have a wick structure disposed on the inner wall thereof. A first plate and a second plate might form the plate body. In the region of the bent portion, the supporting structure is provided. The document discloses several possibilities in forming the supporting structure. In one embodiment a part of the first plate corresponding to and adjacent to the bent portion includes a plurality of recessed portions, the part of the second plate corresponding to and adjacent to the bent portion includes a plurality of protruding portions. The recessed portions and the protruding portion construct the supporting structure, and the recess portions are aligned to the protruding portions (figure 2F).

US 10 517 192 B2 relates to a bendable heat plate that includes a housing and a channel maintaining structure. The housing includes a plurality of flat sections and a bendable section is located between the flat sections. A micro- structural layer is located on the inside of the housing and at least partially filled with fluid. In one embodiment the channel maintaining structure in the bendable section includes a plurality of supporting members arranged at an interval between the first bending portion and the second bending portion, ensuring that the fluid can flow among the support members and the communicating space formed in the bendable section. The channel maintaining structure might also be formed by first ribs and second ribs formed in the housing material, so that the fluid flows among the first ribs and the second ribs. The first bending portion and the second bending portion are embossed to form multiple ribs.

It is the object of the present invention to improve such a heat exchanger.

This object is solved by a heat exchanger according to claim 1.

### BRIEF DESCRIPTION OF THE DRAWINGS

Unless specified otherwise, the accompanying drawings illustrate aspects of the innovative subject matter described herein. Referring to the drawings, wherein like reference numerals indicate similar parts throughout the several views, several examples of heat exchanger systems and methods incorporating aspects of the presently disclosed principles are illustrated by way of example, and not by way of limitation.
Fig. 1A is a schematic perspective second view of a heat exchanger, according to an example embodiment.
Fig. 1B is a schematic perspective first view of a heat exchanger, according to an example embodiment.
Fig. 2A is schematic perspective second view of a heat exchanger fin of the heat exchanger of Fig. 1A and Fig. 1B, according to an example embodiment.
Fig. 2B is schematic perspective first view of the heat exchanger fin of Fig. 2A, according to an example embodiment.
Fig. 2C is schematic perspective third view of the heat exchanger fin of Fig. 2A, according to an example embodiment.
Fig. 2D is schematic perspective fifth view of the heat exchanger fin of Fig. 2A, according to an example embodiment.
Fig. 3A is schematic perspective first view of an at least a first metal sheet of the heat exchanger fin of Fig. 1A and Fig. 1B, according to an example embodiment.
Fig. 3B is schematic perspective first view of an at least a second metal sheet of the heat exchanger fin of Fig. 1A and Fig. 1B, according to an example embodiment.
Fig. 4 is a flow chart illustrating a manufacturing method of the heat exchanger fin of Fig. 1A and Fig. 1B, according to an example embodiment.
Fig. 5A is schematic perspective first view of the heat exchanger fin of Fig. 1A and Fig. 1B following Step 440 of the manufacturing method of Fig. 4, according to an example embodiment.
Fig. 5B is schematic perspective first view of the heat exchanger fin of Fig. 5A following Step 460 of the manufacturing method of Fig. 4, according to an example embodiment.
Fig. 6 is schematic perspective first view of an alternative heat exchanger, according to an example embodiment.

### DETAILED DESCRIPTION

The following describes various principles related to heat exchanger systems and methods by way of reference to specific examples of heat exchanger systems and methods, including specific arrangements and examples of metal sheets and channels embodying innovative concepts. More particularly, but not exclusively, such innovative principles are described in relation to selected examples of heat exchanger systems and methods and well-known functions or constructions are not described in detail for purposes of succinctness and clarity. Nonetheless, one or more of the disclosed principles can be incorporated in various other embodiments of heat exchanger systems and methods to achieve any of a variety of desired outcomes, characteristics, and/or performance criteria.

Thus, heat exchanger systems and methods having attributes that are different from those specific examples discussed herein can embody one or more of the innovative principles, and can be used in applications not described herein in detail.

Example embodiments as disclosed herein are directed to heat exchangers and heat exchanger fins, under vacuum, and having a working fluid therein, and manufacturing methods of the heat exchanger fins. In an embodiment, a heat exchanger comprising a plurality of heat exchanger fins and a base plate is provided. Each heat exchanger fin comprises a first portion (an exchanger enhancement) and a second portion (auxiliary enhancement) having channels therein. The channels are formed by at least a first and second metal sheet. The channels are under vacuum and have a working fluid therein. The closed-loop system of channels of each of the plurality of fins increases the rate of convective heat transfer to or from an environment of the heat exchanger by evaporation of a working fluid, which is spread by a vapor flow filling the vacuum. The vapor flow eventually condenses over cooler surfaces, and, as a result, the heat is distributed from a heat source evaporation interface surface to a larger condensation cooling surface area. An at least a second portion of the heat exchanger fin increases the surface area of the heat source in thermal contact with the heat exchanger via the plurality of fins, thus, further increasing the rate of convective heat transfer to or from an environment of the heat exchanger while not increasing the square area allotted for the heat exchanger applied to an electric and/or electronic elements, devices and systems.

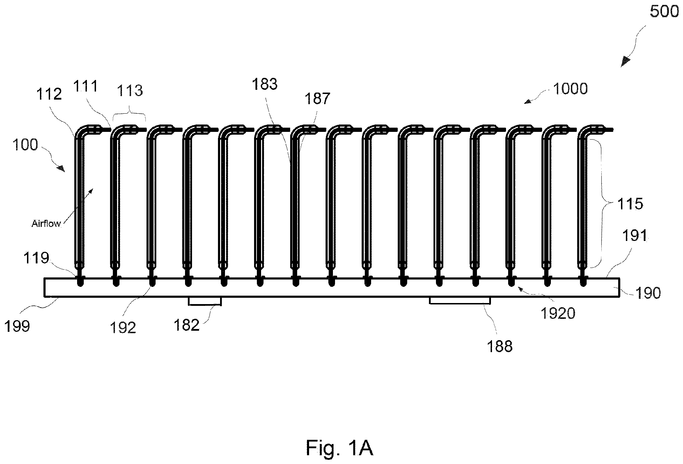

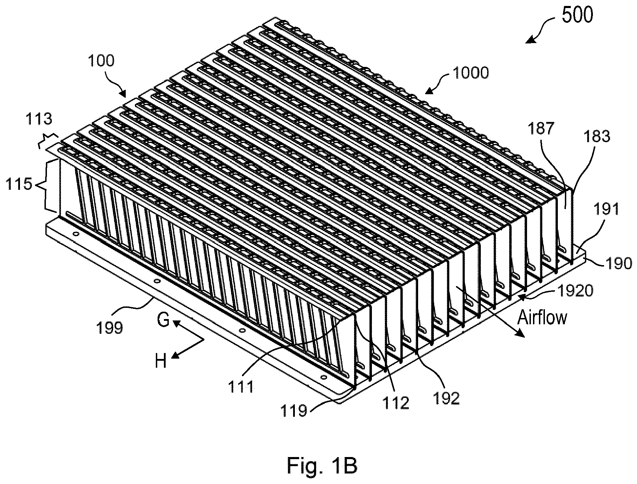

Fig. 1A is a schematic perspective second view of a heat exchanger, according to an example embodiment. Fig. 1B is a schematic perspective first view of a heat exchanger, according to an example embodiment. The heat exchanger 500 may be employed to cool at least one of an electric and/or electronic element, device and/or system. Referring to Figs. 1A and 1B, the heat exchanger 500 comprises a plurality of heat exchanger fins 1000 and a base plate 190. Each heat exchanger fin 100 of the plurality of heat exchanger fins 1000 comprises a fin base 119, a fin intermediary 112, opposite the fin base 119, and a fin tip 111, and a first portion 115 and a second portion 113. The base plate 190 comprises a mounting surface 191 and a contact surface 199, opposite the mounting surface 191. The mounting surface 191 has a plurality of mounting grooves 1920 thereon, substantially parallel thereamong and evenly spaced apart.

The dimensions, depth, and amount of each mounting groove 192 of the plurality of mounting grooves 1920 correspond to the dimensions, height and amount of each fin base 119 of each heat exchanger fin 100. Each fin base 119 of each heat exchanger fin 100 may be thermally and mechanically, permanently attached to each mounting groove 192 by brazing techniques known to those of ordinary skill in the relevant art; however, the embodiments are not limited thereto. Other appropriate methods may be employed, as long as heat may be efficiently and effectively transferred from the base plate 190 to the plurality of heat exchanger fins 1000. In some embodiments, each fin base 119 may be hemmed, reinforcing the strength thereof and increasing the surface area for conductive heat transfer from the base plate 190 to the plurality of heat exchanger fins 1000.

The area occupied by the plurality of heat exchanger fins 1000 on the mounting surface 191 may be varied depending upon application and design requirements. As an example, the area may be smaller, resulting in a non-occupied area of the mounting surface 191 on one or more than one side thereof, or the area may be larger, extending outward over one or more side edges of the mounting surface 191, and the embodiments are not limited thereto.

One or more heat sources of electric and/or electronic elements, devices and/or systems, and/or any combination thereof, may be attached to the contact surface 199, for example and not to be limiting, by fastening or other means known to those of ordinary skill in the relevant art. As long as heat may be efficiently and effectively transferred from the one or more heat sources to the base plate 190.

In some embodiments, a first heat source 182 and a second heat source 188 is attached to the contact surface 199 of the base plate 190 (arrow H in Fig. 1B indicates that the heat sources are spaced apart in that direction). The power requirement and maximum operating temperature allowance of the first heat source 182 may be less than that of the second heat source 188 and when in operation, the first heat source 182 is closer to ground (arrow G in Fig. 1B points to ground) than that of the second heat source 188 (i.e. a main axis M₁ of the first portion 115 and a main axis M₂ of the second portion 113 are oriented substantially vertical, namely in a range ± 15°, preferably in a range ± 7.5° to vertical, when the heat exchanger fin (100; 600) is in use); however, the embodiments are not limited thereto. There may be more than one heat source having different power requirements and maximum operating temperature allowances.

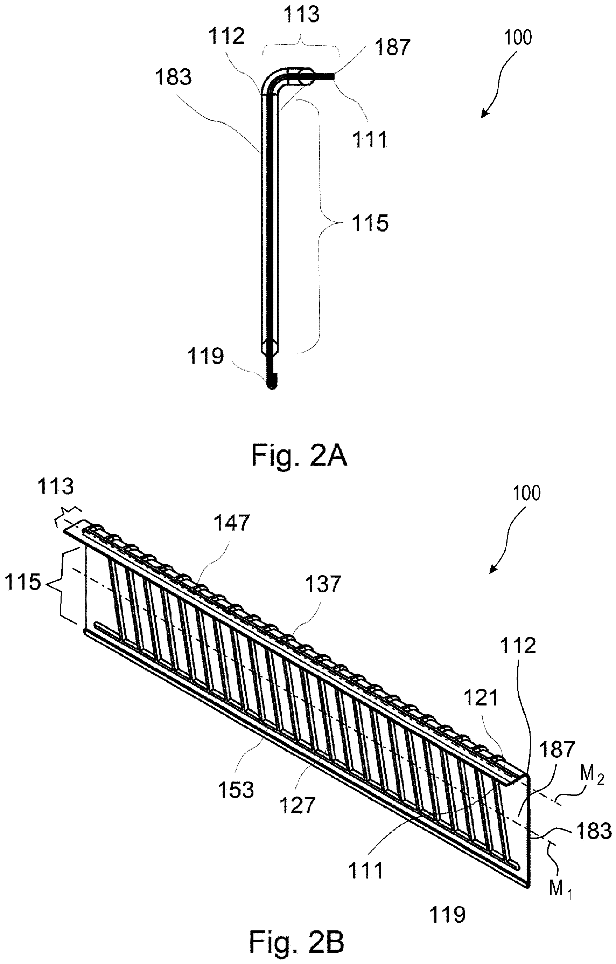

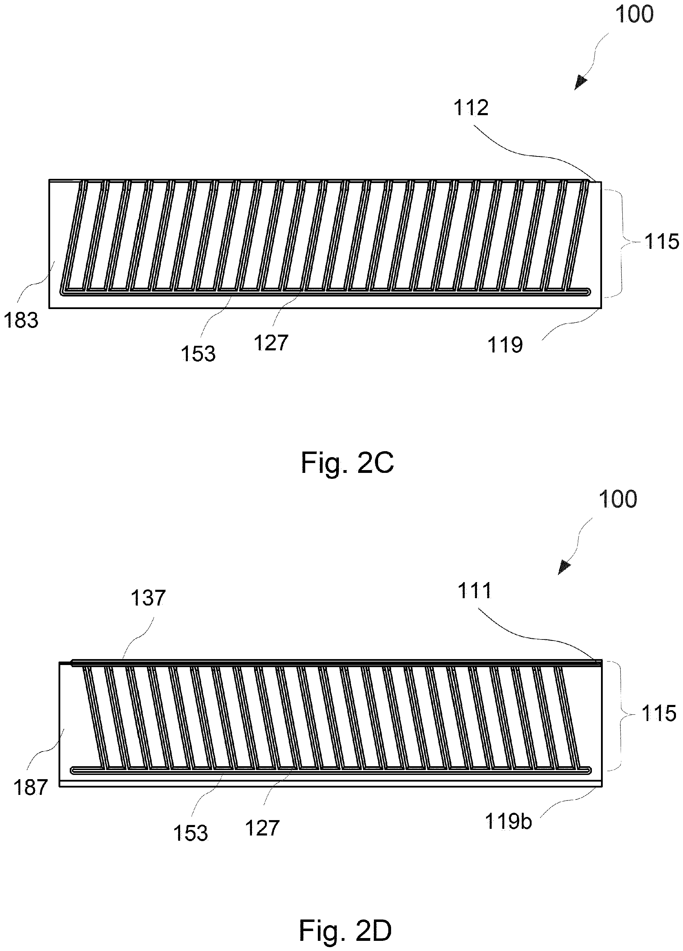

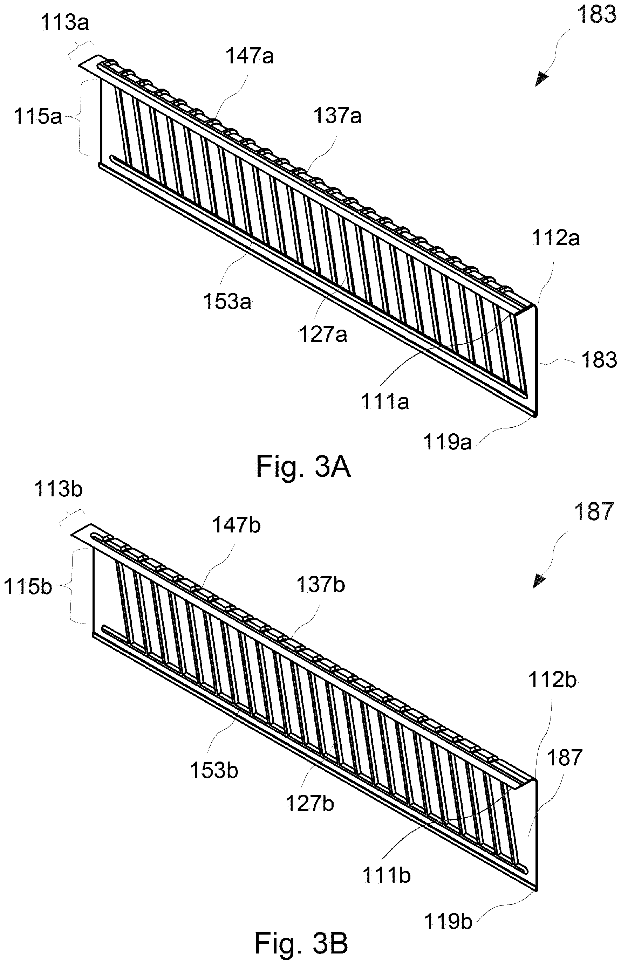

Fig. 2A is schematic perspective second view of a heat exchanger fin of the heat exchanger of Fig. 1A and Fig. 1B, according to an example embodiment. Fig. 2B is schematic perspective first view of the heat exchanger fin of Fig. 2A, according to an example embodiment. Fig. 2C is schematic perspective third view of the heat exchanger fin of Fig. 2A, according to an example embodiment. Fig. 2D is schematic perspective fifth view of the heat exchanger fin of Fig. 2A, according to an example embodiment. Fig. 3A is schematic perspective first view of an at least a first metal sheet of the heat exchanger fin of Fig. 1A and Fig. 1B, according to an example embodiment. Fig. 3B is schematic perspective first view of an at least a second metal sheet of the heat exchanger fin of Fig. 1A and Fig. 1B, according to an example embodiment. Referring to Figs. 2A to 3B, and referring to Figs. 1A and 1B, each of the heat exchanger fins 100 further comprise at least a first metal sheet 183 and at least a second metal sheet 187 having a first inner surface assembled to a second inner surface. The first and second metal sheet 183, 187, form the fin base 119, the fin intermediary 112 opposite the fin base 119 and the fin tip 111 and the second portion 113 comprising the at least a condensation channel 137 and auxiliary channel 147a, 147b, and the first portion 115 comprising the at least a connecting channel 127a, 127b and at least an evaporation channel 153.

In some embodiments, the at least a second portion 113 has at least a condensation channel 137 along and near to an outer perimeter length thereof, or the fin tip 111, and at least an auxiliary channel 147a, 147b, communicating therewith. The first portion 115 has at least an evaporation channel 153 along and near to an outer perimeter length thereof, or the fin base 119, and at least a connecting channel 127a, 127b, communicating therewith. The at least an auxiliary channel 147a, 147b communicates with the at least a connecting channel 127a, 127b, respectively. The at least a condensation channel 137 communicates with the at least an auxiliary channel 147a, 147b communicating with the at least a connecting channel 127a, 127b, respectively, and the at least an evaporation channel 153 communicates with the at least a connecting channel 127a, 127b, respectively. The at least an auxiliary channel 147a, 147b and at least a connecting channel 127a, 127b are evenly disposed parallel and at a slight angle to the at least an evaporation channel 153 and at least a condensation channel 137. The degree of the angle in the embodiments is not limited. As long as downward working fluid flow may be generated.

In some embodiments, the amount of the at least a condensation channel 137 and at least an evaporation channel 153 is one, respectively; however, the embodiments are not limited thereto. In alternative embodiments, there may be more than one condensation channel and more than one evaporation channel. As long as the more than one condensation channel is disposed in the at least a second portion 113, and the condensation channels and the at least an auxiliary channel 147a, 147b are in communication thereamong and as long as the more than one evaporation channel is disposed in the first portion 115, and the evaporation channels and the at least a connecting channel 127a, 127b are in communication thereamong and the at least a connecting channel 127a, 127b is in communication with the at least an auxiliary channel 147a, 147b, respectively.

In some embodiments, there is one at least an auxiliary channel 147a, one at least an auxiliary channel 147b, one at least a connecting channel 127a, and one at least a connecting channel 127b, respectively; however, the embodiments are not limited thereto. In alternative embodiments, there may be two or more at least an auxiliary channel 147a, two or more at least an auxiliary channel 147b, two or more at least a connecting channel 127a, and/or two or more at least a connecting channel 127b, respectively, and any combination thereof. In an example, and not to be limiting, in some embodiments, the amount of the at least an auxiliary channel 147a and at least at least a connecting channel 127a is twenty-four and at least an auxiliary channel 147b and at least at least a connecting channel 127b is twenty-three. As long as the two or more at least an auxiliary channel 147a and/or two or more at least an auxiliary channel 147b are disposed in the at least a second portion 113, respectively, two or more at least a connecting channel 127a and/or two or more at least a connecting channel 127b are disposed in the first portion 115, respectively, and the two more at least an auxiliary channel 147a, two or more at least an auxiliary channel 147b, two or more at least a connecting channel 127a, and/or two or more at least a connecting channel 127b are evenly disposed parallel thereamong and at a slight angle to the at least an evaporation channel 153 and at least a condensation channel 137, respectively.

In some embodiments, the flow volume of the at least a condensation channel 137 and the at least an evaporation channel 153 is generally even thereacross and twice as large as the at least one auxiliary channel 147a, 147b, at least one connecting channel 127a, 127b, respectively; however, the embodiments are not limited thereto. Those of ordinary skill in the relevant art may readily appreciate that the vertical and horizontal dimensions may be varied, respectively, depending upon application and design requirements. As long as the at least one condensation channel 137, at least one auxiliary channel 147a, 147b, at least one connecting channel 127a, 127b, and at least one evaporation channel 153 increases the heat dissipation and thermal performance of each of the plurality of heat exchanger fins 1000 and when operating vertically, the at least a second portion 113 increases the surface area of a heat source in thermal contact with the heat exchanger 500 while not increasing the square area allotted for the heat exchanger 500 and preventing insulating blanket layers around heat source walls from forming and restricting heat transfer.

In some embodiments, each of the plurality of heat exchanger fins 1000, is under vacuum, and has a working fluid therein. The working fluid is distributed naturally in the form of liquid vapor slugs/bubbles throughout the at least one auxiliary channel 147a, 147b of the second portion 113 and at least one connecting channel 127a, 127b and at least an evaporation channel 153 of the first portion 115. Each heat exchanger fin 100 comprises an evaporator region (at least an evaporation channel 153), a condenser region (at least one condensation channel 137), vapor flow region (at least one auxiliary channel 147a, 147b and at least one connecting channel 127a, 127b) extending from the evaporator and condenser regions, respectively. When heat from the at least a first heat source 182 and at least a second heat source 188 is applied to the contact surface 199 of the base plate 190, the heat converts the working fluid to vapor and the vapor bubbles become larger within the vapor flow region. Meanwhile, at the condenser region, heat is being removed and the bubbles are reducing in size. The volume expansion due to vaporization and the contraction due to condensation causes an oscillating motion within the channels (the at least one condensation channel 137, at least one auxiliary channel 147a, 147b, at least one connecting channel 127a, 127b, and at least an evaporation channel 153). The volume of the condenser region is at least equal to or greater than the volume of the evaporator region, facilitating the oscillating motion. The net effect of the temperature gradient between the evaporator region and condenser region and the tensions introduced throughout the at least one condensation channel 137, at least one auxiliary channel 147a, 147b, at least one connecting channel 127a, 127b, and at least an evaporation channel 153, creates a non-equilibrium pressure condition. The increased output pressure gain in downward working fluid flow through the at least one auxiliary channel 147a, 147b, a portion of the at least one connecting channel 127a, 127b, boosts upward oscillation driving forces throughout the at least an evaporation channel 153 and another portion of the at least one connecting channel 127a, 127b, and increased surface area of the second portion 113a, 113b, improving the heat transfer efficiency rate for electric and/or electronic elements, devices and systems. Thermo-fluidic transport is provided within each heat exchanger fin 100 via the self-sustaining oscillation driving forces, whereby the pressure pulsations are fully thermally driven.

Those of ordinary skill in the relevant art may readily appreciate that the shape, width and lengths of the at least one condensation channel 137 and at least one auxiliary channel 147a, 147b of the second portion 113 and at least one connecting channel 127a, 127b and at least an evaporation channel 153 of the first portion 115 may be varied, such as having a wavy shape, having larger or smaller widths and having longer or shorter lengths, respectively, and/or any combination thereof, depending upon application and design requirements and the embodiments are not limited thereto. As long as the at least one condensation channel 137, at least one auxiliary channel 147a, 147b, at least one connecting channel 127a, 127b, and at least an evaporation channel 153 increases the heat dissipation and thermal performance of each of the plurality of heat exchanger fins 1000 and when operating vertically, the at least a second portion 113 increases the surface area of a heat source in thermal contact with the heat exchanger 500 while not increasing the square area allotted for the heat exchanger 500 while preventing insulating blanket layers around heat source walls from forming and restricting heat transfer.

The plurality of heat exchanger fins 1000, under vacuum, having a working fluid in the at least a condensation channel 137, at least an auxiliary channel 147a, 147b, at least a connecting channel 127a, 127b, and at least an evaporation channel 153, increases the heat dissipation and thermal performance of each of the plurality of heat exchanger fins 1000 when compared to solid heat exchanger fins. Also, for electric and/or electronic elements, devices and systems that operate vertically, the at least a second portion 113a, 113b increases the surface area of the heat source in thermal contact with the heat exchanger while not increasing the square area allotted for the heat exchanger. Thus, the rate of convective heat transfer is even further increased while preventing insulating blanket layers around heat source walls from forming and restricting heat transfer.

In some embodiments, the first and second inner surfaces of the first and second metal sheets 183, 187, respectively, are bonded together and integrally formed at areas other than the at least one condensation channel 137 and at least one auxiliary channel 147a, 147b of the second portion 113 and at least one connecting channel 127a, 127b and at least one evaporation channel 153 of the first portion 115; however the embodiments are not limited thereto.

In some embodiments, each heat exchanger fin 100 is made of aluminum, or an aluminum-alloy or the like, and formed by roll-bonding. Fig. 4 is a flow chart illustrating a manufacturing method 400 of the heat exchanger fin 100 of Fig. 2A, according to an example embodiment. Referring to Fig. 4, and referring to Figs. 1A to 3B, the method 400 of manufacturing each heat exchanger fin 100, under vacuum, having a working fluid therein, generally comprises a providing Step 410, a pattern printing Step 415, a roll-bonding Step 420, a forming Step 425, an inflating Step 440, an inserting and vacuuming Step 450 and a closing and cutting Step 460. The first step, Step 410, comprises providing at least a first metal sheet 183 and at least a second metal sheet 187. In some embodiments, the at least a first and second metal sheets 183, 187 are metal coils, unrolled through an unwinder and then aligned by a suitable roller stand. Next, in Step 415, a pattern of at least a condensation channel 137, at least an auxiliary channel 147a, 147b, at least a connecting channel 127a, 127b, and at least an evaporation channel 153 are printed on the at least a first metal sheet 183. In some embodiments, the sheets are cleaned and then printed by a screen printing process employing a graphite pattern of at least a condensation channel 137, at least an auxiliary channel 147a, 147b, at least a connecting channel 127a, 127b, and at least an evaporation channel 153. In some embodiments, each heat exchanger fin 100 further comprises a working channel, extending from one end of the working section 521 to an outer edge of each heat exchanger fin 100. In some embodiments, the screen printing process employing the graphite pattern also prints the working channel. Following, in Step 420, the first inner surface of the at least first metal sheet and second inner surface of the at least second metal sheet are integrally bonded in areas other than the channel printed areas. Thereafter, in Step 425, the second portion 113 is formed by bending. In some embodiments, the bent width of the second portion 113 is generally determined and equal to the distance between each plurality of heat exchanger fins 1000; however, the embodiments are not limited thereto. The bent width may be shorter than the distance between each plurality of heat exchanger fins 1000. As long as the second portion 113 comprises the at least a condensation channel 137 and at least an auxiliary channel 147a, 147b and the channels communicate with the at least a connecting channel 127a, 127b and at least an evaporation channel 153 of the first portion 115.

Those of ordinary skill in the relevant art may readily appreciate that the use of graphite serves as a release agent, thus, preventing the at least first and second metal sheets from integrally bonding in at least the areas of the applied patterned; however, the embodiments are not limited thereto. Any type of method or material may be employed as known and common for those skilled in the relevant art to serve as the release agent. As long as the at least first and second metal sheets are prevented from integrally bonding in the at least areas of the applied following the roll-bonding step.

In some embodiments, the thickness of the at least a first and second metal sheets is between around 0.250 mm and 3.00 mm, having a reduction of each of the at least a first and second metal sheets of between around 40% to 60%; however, the embodiments are not limited thereto. Those of ordinary skill in the relevant art may readily appreciate that thicknesses and reduction of each of the at least a first and second metal sheets can be more or less, depending upon the material, starting thickness, amount of sheets, processes employed, and design requirements for effective and efficient thermal performance.

In some embodiments, the shape of each heat exchanger fin 100 is quadrilateral shaped; however, the embodiments are not limited thereto. Those of skill in the relevant art may readily appreciate that each heat exchanger fin may be of a shape other than quadrilateral shaped, and may be made up of more than one shape according to application and design requirements. As long as the at least a condensation channel 137, at least an auxiliary channel 147a, 147b, at least a connecting channel 127a, 127b, and at least an evaporation channel 153 increases the heat dissipation and thermal performance of each of the plurality of heat exchanger fins 1000 and when operating vertically, the at least a second portion 113a, 113b increases the surface area of a heat source in thermal contact with the heat exchanger 500 while not increasing the square area allotted for the heat exchanger 500.

Fig. 5A is schematic perspective first view of the heat exchanger fin of Fig. 1A and Fig. 1B following Step 440 of the manufacturing method of Fig. 4, according to an example embodiment. Referring to Fig. 5A, and referring to Figs. 1A to 4, next, in Step 430 a working pipe 917 is inserted and secured to a working channel, extending from the one end of a working section 521 to an outer edge of each heat exchanger fin 100. The working pipe allows for communication with the outside atmosphere and the at least a condensation channel 137, at least an auxiliary channel 147a, 147b, at least a connecting channel 127a, 127b, and at least an evaporation channel 153. Following, in Step 440, the channels are inflated via a gas having a pressure configured for even inflation throughout each heat exchanger fin 100. In some embodiments, the gas is atmospheric air having a suitable pressure for inflation; however, the embodiments are not limited thereto. In alternative embodiments, the gas may be nitrogen, oxygen, argon, hydrogen, carbon dioxide, or any of the commonly available commercial gasses or compatible mixtures thereof. In some embodiments, the at least a first and second metal sheet 183, 187 is inserted into a mold before inflating for even inflation throughout each heat exchanger fin 100.

In some embodiments, the height or radius of the at least a condensation channel 137 and at least an evaporation channel 153 from a cross-section is between around 0.125 mm and 1.50 mm and the at least an auxiliary channel 147a, 147b and at least a connecting channel 127a, 127b from a cross-section is between around 0.0625 mm and 0.75 mm; however, the embodiments are not limited thereto. Those of ordinary skill in the relevant art may readily appreciate that the height or radius of the at least a condensation channel 137, at least an auxiliary channel 147a, 147b, at least a connecting channel 127a, 127b, and at least an evaporation channel 153 can be larger or smaller and/or varied, or any combination thereof, depending upon the material, starting thickness, amount of sheets, processes employed, and design requirements for effective and efficient thermal performance.

Next, in Step 450 a working substance is inserted into the working pipe and then air is vacuumed out. Fig. 5B is schematic perspective first view of the heat exchanger fin of Fig. 5A following Step 460 of the manufacturing method of Fig. 4, according to an example embodiment. Referring to Fig. 5B, and referring to Figs. 1A to 5A, in Step 460, the working pipe 917 is closed and sealed by flattening and then bonding thereof, and after cooling, the working channel of the working section 521 is cut, forming each heat exchanger fin 100 comprising the at least a condensation channel 137 and at least an auxiliary channel 147a, 147b of the second portion 113 and at least a connecting channel 127a, 127b and at least an evaporation channel 153 of the first portion 115.

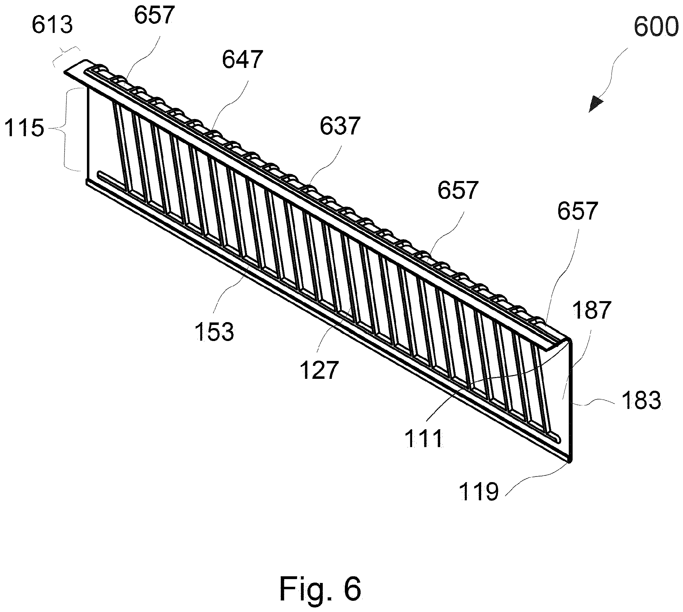

In some embodiments, the second portion 113 comprises the at least a condensation channel 137 and auxiliary channel 147a, 147b; however the embodiments are not limited thereto. In alternative embodiments, the second portion may further comprise additional second portion features. Fig. 6 is schematic perspective first view of an alternative heat exchanger, according to an example embodiment. Referring to Fig. 6, and referring to Figs. 1A to 5B, the second portion 613 further comprises at least an auxiliary through hole 657. The at least an auxiliary through hole 657 is positioned within the second portion 613, while not interfering with the at least a condensation channel 637 and the at least an auxiliary channel 647 (647a, 647b). The at least an auxiliary through hole 657 allows air to pass through portions of the second portion 613, facilitating heat dissipation and thermal performance of each heat exchanger fin 600; especially, when positioned horizontally and the plurality of fins face upward, allowing higher temperature air to more conveniently rise. In some embodiments, the amount of the at least an auxiliary through hole 657 is one; however the embodiments are not limited thereto. In alternative embodiments, the amount of the at least an auxiliary through hole 657 is two or more. In further alternative embodiments, the amount of the at least an auxiliary through hole 657 is twenty four, and positioned between and/or next to the at least an auxiliary channel 647 (647a, 647b). In some embodiments, the shape of the at least an auxiliary through hole 657 is circular-shaped; however, the embodiments are not limited thereto. In alternative embodiments, the shape is quadrilateral-shaped, hexagonal-shaped, or any other suitable shape known by those having ordinary skill in the relevant art. As long as air is allowed to pass through portions of the second portion 613, facilitating heat dissipation and thermal performance of each heat exchanger fin 600.

In some embodiments, each alternative heat exchanger fin 600, further comprising the at least an auxiliary through hole 657, may be employed in the heat exchanger 500 of Figs. 1A to 1B. The heat exchanger 500 comprises a plurality of alternative heat exchanger fins and a base plate 190 to cool at least one of an electric and/or electronic element, device and/or system. The heat exchanger 500 is as described in the embodiments, and for sake of brevity, will not be repeated hereafter.

In some embodiments, like features of each alternative heat exchanger fin 600, further comprising the at least an auxiliary through hole 657, is as described in the embodiments of each heat exchanger fin 100 of Figs. 2A to 3B, and for sake of brevity, will not be repeated hereafter.

In some embodiments, the method 400 of manufacturing each heat exchanger fin 100, under vacuum, having a working fluid therein, of Figs. 4 to 5B, may be employed to manufacture each heat exchange fin 600, further comprising the at least an auxiliary through hole 657. The method 400 employed to manufacture each heat exchange fin 600, further comprising the at least an auxiliary through hole 65 is as described in the embodiments, and for sake of brevity, will not be repeated hereafter.

In some embodiments, the at least a first metal sheet 183 and at least a second metal sheet 187 are made of aluminum, or an aluminum-alloy or the like, and formed by roll-bonding; however, the embodiments are not limited thereto. Those of ordinary skill in the relevant art may readily appreciate that other manufacturing processes may be employed to form the at least a first metal sheet 183 and at least a second metal sheet 187, such as stamping, depending upon material and manufacturing requirements. Those of ordinary skill in the relevant art may also readily appreciate that the at least a first metal sheet 183 and at least a second metal sheet 187 may be made of copper, or a copper-alloy or the like, or other malleable metal heat conducting material having a relatively high thermal conductivity depending upon application and design requirements. As long as each heat exchanger fin 100 may be formed by roll-bonding or stamping, or the like.

In some embodiments, the base plate 190 is made of aluminum, or an aluminum-alloy or the like and suitable for utilizing a brazing technique for thermal and mechanical, permanent brazing of each fin base 119 of each heat exchanger fin 100 to each mounting groove 192; however, the embodiments are not limited thereto. The base plate 190 may also be made of copper, or a copper-alloy or the like, or other malleable metal heat conducting material having a relatively high thermal conductivity depending upon application and design requirements. As long as each fin base 119 may be thermally and mechanically, permanently mounted to each mounting groove 192.

In some embodiments, the base plate 190 is made of a solid malleable metal heat conducting material having a relatively high thermal conductivity; however, the embodiments are not limited thereto. In alternative embodiments, the base plate 190 is under vacuum, and has a working fluid therein. In yet further alternative embodiments, the base plate 190 has an inlet and an outlet, having working fluid flowing therein and thereabout.

In some embodiments, if a stamping process or the like is used to form each heat exchanger fin 100 any bonding method known by those skilled in the relevant art, such as ultrasonic welding, diffusion welding, laser welding and the like, can be employed to bond and integrally form the first and second inner surfaces together at areas other than the formed areas of the at least a condensation channel 137, at least an auxiliary channel 147a, 147b, at least a connecting channel 127a, 127b, and at least an evaporation channel 153. As long as a vacuum seal can be achieved.

In some embodiments, if a stamping process or the like is employed, depending upon dimensions and application, axial or circumferential wick structures, having triangular, rectangular, trapezoidal, reentrant, etc. cross-sectional geometries, may be formed on inner surfaces of the at least a condensation channel 137, at least an auxiliary channel 147a, 147b, at least a connecting channel 127a, 127b, and at least an evaporation channel 153. The wick structure may be used to facilitate the flow of condensed fluid by capillary force back to the evaporation surface, keeping the evaporation surface wet for large heat fluxes.

Those of ordinary skill in the relevant art may readily appreciate that in alternative embodiments, further heat treatment processes can be employed throughout the manufacturing method of each heat exchanger fin 100, and the embodiments are not limited to those described. Additionally, those skilled in the relevant art may readily appreciate that additional steps can be added to the process in order to incorporate additional features into the finished product. Also, the steps can be altered depending upon different requirements. As examples, and not to be limiting: preparatory steps of alloying, casting, scalping and pre-heating: intermediate steps such as intermediate annealing; and finishing steps such as solution heat treatment or final annealing, stretching, leveling, slitting, edge trimming and aging, and the like may be employed.

In some embodiments, each heat exchanger fin 100 comprises two one sided inflated roll-bonded sheets having the at least a condensation channel 137 and at least an auxiliary channel 147a, 147b of the second portion 113 and at least a connecting channel 127a, 127b and at least an evaporation channel 153 of the first portion 115; however, the embodiments are not limited thereto. In alternative embodiments, each heat exchanger fin may comprise the at least a condensation channel, at least an auxiliary channel, at least a connecting channel, and at least an evaporation channel via a one sided inflated roll-bonded sheet. In yet further alternative embodiments, each heat exchanger fin having the at least a condensation channel 137 and at least an auxiliary channel 147a, 147b of the second portion 113 and at least a connecting channel 127a, 127b and at least an evaporation channel 153 of the first portion 115, may be employed as a stand-alone heat exchanger, and the embodiments are not limited thereto.

In some embodiments, the working fluid is made of acetone; however, the embodiments are not limited thereto. Other working fluids can be employed, as can be common for those skilled in the relevant art. As a non-limiting example, the working fluid can comprise cyclopentane or n-hexane. As long as the working fluid can be vaporized by a heat source and the vapor can condense back to the working fluid and flow back to the heat source.

A heat exchanger 500 comprising a plurality of heat exchanger fins 1000 and a base plate 190 is provided. Each heat exchanger fin 100 of the plurality of heat exchanger fins 1000 comprises an at least a second portion 113 having at least a condensation channel 137 and at least an auxiliary channel 147a, 147b and a first portion 115 having at least an evaporation channel 153 and at least a connecting channel 127a, 127b, communicating with the at least an auxiliary channel 147a, 147b, respectively. The second portion 113 and first portion 115 are formed by at least a first metal sheet 183 and at least a second metal sheet 187. The at least a condensation channel 137, at least an auxiliary channel 147a, 147b, at least a connecting channel 127a, 127b, and at least an evaporation channel 153 are under vacuum and have a working fluid therein. The at least a condensation channel 137, at least an auxiliary channel 147a, 147b, at least a connecting channel 127a, 127b, and at least an evaporation channel 153, increases the heat dissipation and thermal performance of each of the plurality of heat exchanger fins 1000. When operating vertically, the at least a second portion 113 increases the surface area of a heat source in thermal contact with the heat exchanger 500 while not increasing the square area allotted for the heat exchanger 500. Thus, the rate of convective heat transfer is even further increased while preventing insulating blanket layers around heat source walls from forming and restricting heat transfer.

In the embodiments, a plurality of heat exchanger fins, under vacuum, having a working fluid therein, each comprising at least a first metal sheet and at least a second metal sheet are provided. The at least a first and second metal sheet form a fin base, a fin intermediary and a fin tip, and a first portion, and a second portion. The second portion comprises at least a condensation channel, and at least an auxiliary channel. The first portion comprises at least an evaporation channel, and at least a connecting channel. Each heat exchanger fin, under vacuum, has a working fluid in the at least a condensation channel, at least an auxiliary channel, at least a connecting channel, and at least an evaporation channel, increasing heat dissipation and thermal performance thereof when compared to solid heat exchanger fins. Also, for electric and/or electronic elements, devices and systems that operate vertically, the at least a second portion increases the surface area of the heat source in thermal contact with the heat exchanger while not increasing the square area allotted for the heat exchanger. Thus, the rate of convective heat transfer is even further increased while preventing insulating blanket layers around heat source walls from forming and restricting heat transfer.

Directions and references to an element, such as "up," "down,", "upper," "lower," "horizontal," "vertical," "left," "right," and the like, do not imply absolute relationships, positions, and/or orientations. Terms of an element, such as "first" and "second" are not literal, but, distinguishing terms. As used herein, terms "comprises" or "comprising" encompass the notions of "including" and "having" and specify the presence of elements, operations, and/or groups or combinations thereof and do not imply preclusion of the presence or addition of one or more other elements, operations and/or groups or combinations thereof. Sequence of operations do not imply absoluteness unless specifically so stated. Reference to an element in the singular, such as by use of the article "a" or "an", is not intended to mean "one and only one" unless specifically so stated, but rather "one or more". As used herein, "and/or" means "and" or "or", as well as "and" and "or." As used herein, ranges and subranges mean all ranges including whole and/or fractional values therein and language which defines or modifies ranges and subranges, such as "at least," "greater than," "less than," "no more than," and the like, mean subranges and/or an upper or lower limit. All structural and functional equivalents to the elements of the various embodiments described throughout the disclosure that are known or later come to be known to those of ordinary skill in the relevant art are intended to be encompassed by the features described and claimed herein. Moreover, nothing disclosed herein is intended to be dedicated to the public regardless of whether such disclosure may ultimately explicitly be recited in the claims.

In view of the many possible embodiments to which the disclosed principles can be applied, the scope of protection is as defined by the appended claims.

## Claims

1. A heat exchanger (500) comprising a base plate (190) and at least one heat exchanger fin (100; 600), whereby the base plate (190) comprises a mounting surface (191) and a contact surface (199), opposite the mounting surface (191), whereby the at least one heat exchanger fin (100; 600) comprises a fin base (119), a fin tip (111) and a channel system that is provided between the fin base (119) and the fin tip (111) and that is under vacuum and has a working fluid therein, whereby the fin base (119) of the at least one heat exchanger fin (100; 600) is attached to the mounting surface (191) of the base plate (190) for heat transfer between the base plate (190) and the at least one heat exchanger fin (100; 600), whereby the channel system is at least divided into a first part included in a first portion (115) of the heat exchanger fin (100; 600) and a second part included in a second portion (113; 613) of the heat exchanger fin (100; 600), and whereby the first portion (115) of the at least one heat exchanger fin (100; 600) stands upright on the mounting surface (191), wherein the channel system comprises an evaporator region, a condenser region and a vapor flow region, whereby the evaporator region is disposed in the first portion (115), the condenser region is disposed in the second portion (113; 613) and the vapor flow region is disposed in the first portion (115) and the second portion (113; 613) and connects the evaporator region with the condenser region, wherein the evaporator region of the first portion (115) has at least one evaporation channel (153), a first part of the vapor flow region is disposed in the first portion (115) and has at least one connecting channel (127a, 127b) communicating with the at least one evaporation channel (153), a second part of the vapor flow region is disposed in the second portion (113; 613) and has at least one auxiliary channel (147a, 147b; 647a, 647b) communicating with at least one of the at least one connecting channel (127a, 127b); wherein the condenser region of the second portion (113; 613) has at least one condensation channel (137) communicating with the at least one auxiliary channel (147a, 147b; 647a, 647b); and wherein the at least one evaporation channel (153) extends along and near to an outer perimeter length of the first portion (115) of the heat exchanger fin (100; 600) and along and near to the mounting surface (191) of the base plate (190), **characterized in that** the first portion (115) and the second portion (113; 613) are angled towards each other in an angle range of >0° to <180°.

2. The heat exchanger (500) of claim 1, wherein a second portion (113; 613) of a heat exchanger fin (100; 600) has a width which is in a range of equal to and maximum 20% smaller than the distance between the respective heat exchanger fin (100; 600) and the corresponding neighboring heat exchanger fin (100; 600) in the direction of which the second portion (113; 613) extends.

3. The heat exchanger (500) of claim 1 or 2, wherein the base plate (190) and the at least one heat exchanger fin (100; 600) are substantially oriented vertical, namely in a range ± 15°, preferably in a range ± 7.5° to vertical, when the heat exchanger (500) is used, wherein the contact surface (199) is in contact with a first heat source (182) and a second heat source (188), and wherein the power requirement and maximum operating temperature allowance of the first heat source (182) is less than that of the second heat source (188) and when in operation, the first heat source (182) is closer to ground (G) than the second heat source (188).

4. The heat exchanger (500) of one of claims 1 to 3, wherein the angle range is 130° to 170°.

5. The heat exchanger (500) of one of claims 1 to 3, wherein the angle range is 75° to 105°, preferably substantially limited to 90°.

6. The heat exchanger (500) of one of claims 1 to 5, wherein the channel system is configured such that a fully thermally driven flow of the working fluid through the channel system in a closed loop configuration is producible.

7. The heat exchanger (500) of one of claims1 to 6, wherein the volume of the condenser region is at least equal to or greater than the volume of the evaporator region.

8. The heat exchanger (500) of one of claims 1 to 7, wherein the at least one connecting channel (127a, 127b) and/or the at least one auxiliary channel (147a, 147b; 647a, 647b) is or are disposed in a slight angle to the at least one evaporation channel (153) and/or the at least one condensation channel (137), respectively.

9. The heat exchanger (500) of one of claims 1 to 8, wherein at least two connecting channels (127a, 127b) and/or at least two auxiliary channels (147a, 147b; 647a, 647b) are disposed substantially parallel to each other, respectively, and/or wherein the at least one evaporation channel (153) and the at least one condensation channel (137) are disposed substantially parallel to each other.

10. The heat exchanger (500) of one of claims 1 to 9, wherein a main axis (M₁) of the first portion (115) and a main axis (M₂) of the second portion (113; 613) are oriented substantially vertical, namely in a range ± 15°, preferably in a range ± 7.5° to vertical, when the heat exchanger fin (100; 600) is in use.

11. The heat exchanger (500) of one of claims 1 to 10, wherein the at least one connecting channel (127a, 127b) and/or the at least one auxiliary channel (147a, 147b; 647a, 647b) extend upwardly inclined to enhance downward working fluid flow.

12. The heat exchanger (500) of one of claims 1 to 11, wherein the second portion (113; 613) comprises at least one auxiliary through hole (657) that does not interfere with the at least one condensation channel (137) and the at least one auxiliary channel (147a, 147b; 647a, 647b).

13. A method of manufacturing a heat exchanger (100; 600) according to one of claims 1 to 12, comprising the following steps:
- Providing at least one first metal sheet (183) and at least one second metal sheet (187),
- Vacuum tight bonding the inner surface of the at least one first metal sheet (183) and the inner surface of the at least one second metal sheet (187) in areas other than channel forming areas,
- Bending the at least one first metal sheet (183) and the at least one second metal sheet (187) to at least preform a second portion (113; 613),
- Inserting a working fluid into the channel system and vacuuming out air, and
- Closing the channel system.

14. The method of claim 13, comprising the following steps:
- Printing a pattern of the channel system on the at least one first metal sheet (183),
- Roll-bonding the inner surface of the at least one first metal sheet (183) and inner surface of the at least one second metal sheet (187) in areas other than the channels printed areas, and
- Inflating the channel system via a gas.

15. The method of claim 13 or 14, wherein the channel system at least initially comprises an open working channel in a working section (521) and the method further comprises the following steps:
- Inserting and securing a working pipe (917) to the working channel,
- After inserting the working fluid closing an sealing the working pipe (917) and/or the working channel by flattening and then bonding thereof, and
- At least partially cutting off the working section (521) comprising the working channel and the working pipe (917).

16. The method of one of claims 13 to 15, comprising the following step:
- At least partially forming axial and/or circumferential wick structures on inner surfaces of the channel system forming areas of the at least one first metal sheet (183) and/or the at least one second metal sheet (187), especially in an at least one condensation channel forming area and/or an at least one connecting channel forming area and/or an at least one auxiliary channel forming area and/or an at least one evaporation channel forming area.

## Patentansprüche

1. Ein Wärmetauscher (500) umfassend eine Grundplatte (190) und mindestens eine Wärmetauscherrippe (100; 600), wobei die Grundplatte (190) eine Montagefläche (191) und eine der Montagefläche (191) gegenüberliegende Kontaktfläche (199) aufweist, wobei die mindestens eine Wärmetauscherrippe (100; 600) eine Rippenbasis (119), eine Rippenspitze (111) und ein zwischen der Rippenbasis (119) und der Rippenspitze (111) vorgesehene Kanalsystem umfasst, das unter Vakuum steht und in dem sich ein Arbeitsfluid befindet, wobei die Rippenbasis (119) der mindestens einen Wärmetauscherrippe (100; 600) an der Montagefläche (191) der Grundplatte (190) angebracht ist, für eine Wärmeübertragung zwischen der Grundplatte (190) und der mindestens einen Wärmetauscherrippe (100), wobei das Kanalsystem zumindest in einen ersten Teil, der in einem ersten Abschnitt (115) der Wärmetauscherrippe (100; 600) enthalten ist, und einen zweiten Teil, der in einem zweiten Abschnitt (113; 613) der Wärmetauscherrippe (100; 600) enthalten ist, unterteilt ist, und wobei der erste Abschnitt (115) der mindestens einen Wärmetauscherrippe (100; 600) aufrecht auf der Montagefläche (191) steht, wobei das Kanalsystem einen Verdampferbereich, einen Kondensatorbereich und einen Dampfstrombereich umfasst, wobei der Verdampferbereich in dem ersten Abschnitt (115) angeordnet ist, der Kondensatorbereich in dem zweiten Abschnitt (113; 613) angeordnet ist und der Dampfstrombereich in dem ersten Abschnitt (115) und dem zweiten Abschnitt (113; 613) angeordnet ist und den Verdampferbereich mit dem Kondensatorbereich verbindet, wobei der Verdampferbereich des ersten Abschnitts (115) mindestens einen Verdampfungskanal (153) aufweist, ein erster Teil des Dampfstrombereichs in dem ersten Abschnitt (115) angeordnet ist und mindestens einen Verbindungskanal (127a, 127b) aufweist, der mit dem mindestens einen Verdampfungskanal (153) in Verbindung steht, ein zweiter Teil des Dampfstrombereichs in dem zweiten Abschnitt (113; 613) angeordnet ist und mindestens einen Hilfskanal (147a, 147b; 647a, 647b) aufweist, der mit mindestens einem der mindestens einen Verbindungskanäle (127a, 127b) in Verbindung steht; wobei der Kondensatorbereich des zweiten Abschnitts (113; 613) mindestens einen Kondensationskanal (137) aufweist, der mit dem mindestens einen Hilfskanal (147a, 147b; 647a, 647b) in Verbindung steht; und wobei sich der mindestens eine Verdampfungskanal (153) entlang und nahe einer äußeren Umfangslänge des ersten Abschnitts (115) der Wärmetauscherrippe (100; 600) und entlang und nahe der Montagefläche (191) der Grundplatte (190) erstreckt, **dadurch gekennzeichnet, dass** der erste Abschnitt (115) und der zweite Abschnitt (113; 613) in einem Winkelbereich von >0° bis <180° gegeneinander abgewinkelt sind.

2. Der Wärmetauscher (500) nach Anspruch 1, wobei ein zweiter Abschnitt (113; 613) einer Wärmetauscherrippe (100; 600) eine Breite aufweist, die in einem Bereich von gleich und maximal 20% kleiner ist als der Abstand zwischen der jeweiligen Wärmetauscherrippe (100; 600) und der entsprechenden benachbarten Wärmetauscherrippe (100; 600) in der Richtung, in der sich der zweite Abschnitt (113; 613) erstreckt.

3. Der Wärmetauscher (500) nach Anspruch 1 oder 2, wobei die Grundplatte (190) und die mindestens eine Wärmetauscherrippe (100) im Wesentlichen vertikal, und zwar in einem Bereich ± 15°, bevorzugt in einem Bereich ± 7,5° zur Vertikalen, ausgerichtet sind, wenn der Wärmetauscher (500) in Betrieb ist, und wobei die Kontaktfläche (199) mit einer ersten Wärmequelle (182) und einer zweiten Wärmequelle (188) in Kontakt steht, und wobei der Energiebedarf und die maximale Betriebstemperaturabweichung der ersten Wärmequelle (182) geringer ist als die der zweiten Wärmequelle (188) und die erste Wärmequelle (182) im Betrieb näher am Boden (G) angeordnet ist als die zweite Wärmequelle (188).

4. Der Wärmetauscher (500) nach einem der Ansprüche 1 bis 3, wobei der Winkelbereich 130° bis 170° beträgt.

5. Der Wärmetauscher (500) nach einem der Ansprüche 1 bis 3, wobei der Winkelbereich 75° bis 105° beträgt, vorzugsweise im Wesentlichen begrenzt auf 90°.

6. Der Wärmetauscher (500) nach einem der Ansprüche 1 bis 5, wobei das Kanalsystem so ausgebildet ist, dass eine vollständig thermisch angetriebene Durchströmung des Arbeitsfluids durch das Kanalsystem in einem geschlossenen Kreislauf erzeugbar ist.

7. Der Wärmetauscher (500) nach einem der Ansprüche 1 bis 6, wobei das Volumen des Kondensatorbereichs mindestens gleich groß oder größer ist als das Volumen des Verdampferbereichs.

8. Der Wärmetauscher (500) nach einem der Ansprüche 1 bis 7, wobei der mindestens eine Verbindungskanal (127a, 127b) und/oder der mindestens eine Hilfskanal (147a, 147b; 647a, 647b) in einem geringen Winkel zu dem mindestens einen Verdampfungskanal (153) und/oder dem mindestens Kondensationskanal (137) angeordnet ist oder sind.

9. Der Wärmetauscher (500) nach einem der Ansprüche 1 bis 8, wobei mindestens zwei Verbindungskanäle (127a, 127b) und/oder mindestens zwei Hilfskanäle (147a, 147b; 647a, 647b) im Wesentlichen parallel zueinander angeordnet sind, und/oder wobei der mindestens ein Verdampfungskanal (153) und der mindestens eine Kondensationskanal (137) im Wesentlichen parallel zueinander angeordnet sind.

10. Der Wärmetauscher (500) nach einem der Ansprüche 1 bis 9, wobei eine Hauptachse (M₁) des ersten Abschnitts (115) und eine Hauptachse (M₂) des zweiten Abschnitts (113; 613) im Wesentlichen vertikal ausgerichtet sind, und zwar in einem Bereich von ± 15°, vorzugsweise in einem Bereich ± 7,5° zur Vertikalen ausgerichtet sind, wenn die Wärmetauscherrippe (100; 600) in Gebrauch ist.

11. Der Wärmetauscher (500) nach einem der Ansprüche 1 bis 10, wobei der mindestens eine Verbindungskanal (127a, 127b) und/oder der mindestens eine Hilfskanal (147a, 147b; 647a, 647b) nach oben geneigt verlaufen, um die Abwärtsströmung des Arbeitsfluids zu verbessern.

12. Der Wärmetauscher (500) nach einem der Ansprüche 1 bis 11, wobei der zweite Abschnitt (113; 613) mindestens ein Hilfsdurchgangsloch (657) aufweist, das den mindestens einen Kondensationskanal (137) und den mindestens einen Hilfskanal (147a, 147b; 647a, 647b) nicht beeinträchtigt.

13. Verfahren zur Herstellung eines Wärmetauschers (100; 600) nach einem der Ansprüche 1 bis 12, umfassend die folgenden Schritte:
- Bereitstellen mindestens eines ersten Metallblechs (183) und mindestens eines zweites Metallblechs (187),
- Vakuumdichtes Verbinden der Innenfläche des mindestens einen ersten Metallblechs (183) und der Innenfläche des mindestens einen zweiten Metallblechs (187) in anderen Bereichen als den kanalbildenden Bereichen,
- Biegen des mindestens einen ersten Metallblechs (183) und des mindestens einen zweiten Metallblechs (187), um einen zweiten Abschnitt (113; 613) zumindest vorzuformen,
- Einbringen eines Arbeitsfluids in das Kanalsystem und Absaugen von Luft, und
- Verschließen des Kanalsystems.

14. Das Verfahren nach Anspruch 13, umfassend die folgende Schritte:
- Aufdrucken eines Kanalsystemmusters auf das mindestens eine erste Metallblech (183),
- Walzplattieren der Innenfläche des mindestens einen ersten Metallblechs (183) und der Innenfläche des mindestens einen zweiten Metallblechs (187) in anderen Bereichen als den aufgedruckten Kanalbereichen, und
- Aufblasen des Kanalsystems durch ein Gas.

15. Das Verfahren nach Anspruch 13 oder 14, wobei das Kanalsystem zumindest anfänglich in einem Arbeitsabschnitt (521) einen offenen Arbeitskanal aufweist und wobei das Verfahren ferner die folgenden Schritte umfasst:
- Einführen und Befestigen eines Arbeitsrohrs (917) in den Arbeitskanal,
- Verschließen und Abdichten des Arbeitsrohrs (917) und/oder des Arbeitskanals nach dem Einbringen des Arbeitsfluids durch Abflachen und anschließendes Verbinden, und
- zumindest teilweises Abschneiden des den Arbeitskanal und das Arbeitsrohr (917) umfassenden Arbeitsabschnitts (512).

16. Das Verfahren nach einem der der Ansprüche 13 bis 15, umfassend den folgenden Schritt:
- zumindest teilweises Ausbilden von axialen und/oder umlaufenden Mantelstrukturen auf Innenflächen der das Kanalsystem ausbildenden Bereiche des mindestens einen ersten Metallblechs (183) und/oder des mindestens einen zweiten Metallblechs (187), insbesondere in einem mindestens einen Kondensationskanal ausbildenden Bereich und/oder in einem mindestens einen Verbindungskanal ausbildenden Bereich und/oder in einem mindestens einen Hilfskanal ausbildenden Bereich und/oder in einem einen Verdampfungskanal ausbildenden Bereich.

## Revendications

1. Échangeur de chaleur (500) comprenant une plaque de base (190) et au moins une ailette d'échangeur de chaleur (100 ; 600), la plaque de base (190) comprend une surface de montage (191) et une surface de contact (199), opposée à la surface de montage (191), l'au moins une ailette d'échangeur de chaleur (100 ; 600) comprend une base d'ailette (119), une pointe d'ailette (111) et un système de canaux qui est fourni entre la base d'ailette (119) et la pointe d'ailette (111), qui est sous vide et dans lequel se trouve un fluide de travail, la base d'ailette (119) de l'au moins une ailette d'échangeur de chaleur (100 ; 600) étant fixée à la surface de montage (191) de la plaque de base (190) pour le transfert de chaleur entre la plaque de base (190) et l'au moins une ailette d'échangeur de chaleur (100 ; 600), le système de canaux étant fixé à la surface de montage (191) de la plaque de base (190) pour le transfert de chaleur entre la plaque de base (190) et l'au moins une ailette d'échangeur de chaleur (100 ; 600), le système de canaux étant au moins divisé en une première partie incluse dans une première partie (115) de l'ailette d'échangeur de chaleur (100 ; 600) et une deuxième partie incluse dans une deuxième partie (113 ; 613) de l'ailette d'échangeur de chaleur (100 ; 600), et la première partie (115) de l'au moins une ailette d'échangeur de chaleur (100 ; 600) repose verticalement sur la surface de montage (191), dans lequel le système de canaux comprend une région d'évaporation, une région de condensation et une région d'écoulement de vapeur, la région d'évaporation étant disposée dans la première partie (115), la région de condensation étant disposée dans la deuxième partie (113 ; 613) et la région d'écoulement de vapeur est disposée dans la première partie (115) et la deuxième partie (113 ; 613) et relie la région de l'évaporateur à la région du condenseur, dans lequel la région de l'évaporateur de la première partie (115) comporte au moins un canal d'évaporation (153), une première partie de la région d'écoulement de vapeur est disposée dans la première partie (115) et comporte au moins un canal de connexion (127a, 127b) communiquant avec l'au moins un canal d'évaporation (153), une deuxième partie de la région d'écoulement de vapeur est disposée dans la deuxième partie (113 ; 613) et comporte au moins un canal auxiliaire (147a, 147b ; 647a, 647b) communiquant avec au moins un des au moins un canal de connexion (127a, 127b) ; dans lequel la région du condenseur de la deuxième partie (113 ; 613) a au moins un canal de condensation (137) communiquant avec l'au moins un canal auxiliaire (147a, 147b ; 647a, 647b) ; et dans lequel l'au moins un canal d'évaporation (153) s'étend le long et à proximité d'une longueur de périmètre extérieur de la première partie (115) de l'ailette d'échangeur de chaleur (100 ; 600) et le long et à proximité de la surface de montage (191) de la plaque de base (190), **caractérisé en ce que** la première partie (115) et la deuxième partie (113 ; 613) sont inclinées l'une vers l'autre dans une plage d'angles comprise entre > 0° et < 180°.

2. Échangeur de chaleur (500) selon la revendication 1, dans lequel une deuxième partie (113 ; 613) d'une ailette d'échangeur de chaleur (100 ; 600) a une largeur qui est dans une plage de égale et maximum 20 % plus petite que la distance entre l'ailette d'échangeur de chaleur (100 ; 600) respective et l'ailette d'échangeur de chaleur (100 ; 600) voisine correspondante dans la direction dans laquelle la deuxième partie (113 ; 613) s'étend.

3. Échangeur de chaleur (500) selon la revendication 1 ou 2, dans lequel la plaque de base (190) et l'au moins une ailette d'échangeur de chaleur (100 ; 600) sont orientées sensiblement à la verticale, à savoir dans une plage de ± 15°, de préférence dans une plage de ± 7,5° par rapport à la verticale, lorsque l'échangeur de chaleur (500) est utilisé, dans lequel la surface de contact (199) est en contact avec une première source de chaleur (182) et une deuxième source de chaleur (188), et dans lequel la puissance requise et la température de fonctionnement maximale autorisée de la première source de chaleur (182) sont inférieures à celles de la deuxième source de chaleur (188) et, en fonctionnement, la première source de chaleur (182) est plus proche du sol (G) que la deuxième source de chaleur (188).

4. Échangeur de chaleur (500) selon l'une des revendications 1 à 3, dans lequel la plage d'angle est comprise entre 130° et 170°.

5. Échangeur de chaleur (500) selon l'une des revendications 1 à 3, dans lequel la plage d'angle est comprise entre 75° et 105°, de préférence sensiblement limitée à 90°.

6. Échangeur de chaleur (500) selon l'une des revendications 1 à 5, dans lequel le système de canaux est configuré de telle sorte qu'un écoulement entièrement thermiquement entraîné du fluide de travail à travers le système de canaux dans une configuration en boucle fermée est productible.

7. Échangeur de chaleur (500) selon l'une des revendications 1 à 6, dans lequel le volume de la région du condenseur est au moins égal ou supérieur au volume de la région de l'évaporateur.

8. Échangeur de chaleur (500) selon l'une des revendications 1 à 7, dans lequel l'au moins un canal de connexion (127a, 127b) et/ou l'au moins un canal auxiliaire (147a, 147b ; 647a, 647b) est ou sont disposé·s dans un angle faible par rapport au au moins un canal d'évaporation (153) et/ou au moins un canal de condensation (137), respectivement.

9. Échangeur de chaleur (500) selon l'une des revendications 1 à 8, dans lequel au moins deux canaux de connexion (127a, 127b) et/ou au moins deux canaux auxiliaires (147a, 147b ; 647a, 647b) sont disposés sensiblement parallèlement l'un à l'autre, respectivement, et/ou dans lequel l'au moins un canal d'évaporation (153) et l'au moins un canal de condensation (137) sont disposés sensiblement parallèlement l'un à l'autre.

10. Échangeur de chaleur (500) selon l'une des revendications 1 à 9, dans lequel un axe principal (M₁) de la première partie (115) et un axe principal (M₂) de la deuxième partie (113 ; 613) sont orientés sensiblement à la verticale, à savoir dans une plage de ± 15°, de préférence dans une plage de ± 7,5° par rapport à la verticale, lorsque l'ailette d'échangeur de chaleur (100 ; 600) est en cours d'utilisation.

11. Échangeur de chaleur (500) selon l'une des revendications 1 à 10, dans lequel l'au moins un canal de connexion (127a, 127b) et/ou l'au moins un canal auxiliaire (147a, 147b ; 647a, 647b) s'étendent inclinés vers le haut pour améliorer l'écoulement du fluide de travail vers le bas.

12. Échangeur de chaleur (500) selon l'une des revendications 1 à 11, dans lequel la deuxième partie (113 ; 613) comprend au moins un trou traversant auxiliaire (657) qui n'interfère pas avec l'au moins un canal de condensation (137) et l'au moins un canal auxiliaire (147a, 147b ; 647a, 647b).

13. Procédé de fabrication d'un échangeur de chaleur (100 ; 600) selon l'une des revendications 1 à 12, comprenant les étapes suivantes :
- fournir au moins une première feuille métallique (183) et au moins une deuxième feuille métallique (187),
- coller sous vide la surface intérieure de l'au moins une première feuille métallique (183) et la surface intérieure de l'au moins une deuxième feuille métallique (187) dans les zones autres que les zones de formation des canaux,
- plier l'au moins une première feuille métallique (183) et l'au moins une deuxième feuille métallique (187) pour au moins préformer une deuxième partie (113 ; 613),
- insérer un fluide de travail dans le système de canaux et aspirer l'air, et
- fermer le système de canaux.

14. Procédé selon la revendication 13, comprenant les étapes suivantes :
- impression d'un motif du système de canaux sur l'au moins une première feuille métallique (183),
- coller au rouleau la surface intérieure de l'au moins une première feuille métallique (183) et la surface intérieure de l'au moins une deuxième feuille métallique (187) dans les zones autres que les zones imprimées des canaux, et
- gonfler le système de canaux en utilisant un gaz.

15. Procédé selon la revendication 13 ou 14, dans lequel le système de canaux comprend au moins initialement un canal de travail ouvert dans une section de travail (521) et le procédé comprend en outre les étapes suivantes :
- insérer et fixer un tuyau de travail (917) dans le canal de travail,
- après avoir inséré le fluide de travail, fermer et sceller le tuyau de travail (917) et/ou le canal de travail en les aplatissant puis en les collant, et
- découper au moins de manière partielle la section de travail (521) comprenant le canal de travail et le tuyau de travail (917).

16. Procédé selon l'une des revendications 13 à 15, comprenant l'étape suivante :
- former au moins partiellement des structures de mèches axiales et/ou circonférentielles sur les surfaces intérieures des zones de formation du système de canaux de l'au moins une première feuille métallique (183) et/ou de l'au moins une deuxième feuille métallique (187), notamment dans une au moins une zone de formation du canal de condensation et/ou une au moins une zone de formation du canal de connexion et/ou une au moins une zone de formation du canal auxiliaire et/ou une au moins une zone de formation du canal d'évaporation.
